(19) Europäisches Patentamt
European Patent Office
Office européen des brevets

(11) **EP 2 876 818 B1**

(12) **EUROPEAN PATENT SPECIFICATION**

(45) Date of publication and mention
of the grant of the patent:
**08.03.2017 Bulletin 2017/10**

(51) Int Cl.:
***H04B 3/54*** *(2006.01)*

(21) Application number: **13819383.4**

(86) International application number:
**PCT/ES2013/000178**

(22) Date of filing: **19.07.2013**

(87) International publication number:
**WO 2014/013105 (23.01.2014 Gazette 2014/04)**

(54) **SYSTEM AND METHOD FOR DETECTING THE METERS OF EACH LOW-VOLTAGE LINE OF TRANSFORMATION CENTERS**

SYSTEM UND VERFAHREN ZUR ERKENNUNG DER ABMESSUNGEN JEDER NIEDERSPANNUNGSLEITUNG VON TRANSFORMATIONSZENTREN

SYSTÈME ET PROCÉDÉ POUR DÉTECTER LES COMPTEURS DE CHAQUE LIGNE BASSE TENSION DES CENTRES DE TRANSFORMATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.07.2012 ES 201200742**

(43) Date of publication of application:
**27.05.2015 Bulletin 2015/22**

(73) Proprietor: **Ziv Aplicaciones y Tecnológia S.L.**
**48016 Zamudio, Bizkaia (ES)**

(72) Inventors:
• **MASSOT REDONDO, Rafael**
**48016 Zamudio, Bizkaia (ES)**

• **ARZUAGA MANSURI, Aitor**
**48016 Zamudio, Bizkaia (ES)**
• **LLANO PALACIOS, Asier**
**48016 Zamudio, Bizkaia (ES)**

(74) Representative: **Juncosa Miro, Jaime et al**
**Torner, Juncosa i Associates, S.L.**
**Gran Via de les Corts**
**Catalanes, 669 bis, 1o, 2a**
**08013 Barcelona (ES)**

(56) References cited:
**WO-A1-2005/059572      WO-A2-2008/125696**
**US-A- 5 995 911      US-A1- 2005 083 206**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a new system and method for automatically detecting meters depending on a low-voltage transformation center in each of the lines thereof, i.e., digital meters incorporating PLC (Power Line Communications) communication protocol technology, which is used in public, open and standard meter and power line management.

The present system and method is a significant development for intelligent infrastructure and client management, with the possibility of balancing network load, detecting blown fuses and even detecting fraud in lines, all with the security provided by knowing all the meters depending on a transformation center and each of the low-voltage lines forming said center, and the direct effect of any alteration therein, and the power supply.

Background of the Invention

The present invention relates to a system for detecting meters, using the own PLC communication, by means of an inductive sensor that will be placed in each of the low-voltage output lines of the transformation center, and said sensor will be responsible for accounting for the intensity or level of power going through said line as a result of the communication between the concentrator and the base node of the PLC, and the meters using the PLC communication protocol, such that through a specific statistics program it studies and evaluates the level of signals received by the inductive sensor to thus determine the meters depending on said line.

A very common problem for electric utility companies is that they do not have a reliable database that reflects the topology of the low-voltage distribution network. In other words, they do not know which lines serve which clients, such that they cannot predict which clients will be affected by a problem or power outage, or if said problem or power outage can affect unforeseen clients.

This arises from the difficulty in maintaining said information, because in many cases the distribution network has been deployed for a long time (particularly in city centers), and successive failures and reconnections have required performing topological modifications that have not been correctly reflected.

Line detection consists of real time unique assignment of each single-phase or three-phase meter to the low-voltage line powering same from the transformation center. This will allow obtaining a reliable up-to-date photo of the low-voltage network of the electric utility company.

With said information, multiple applications that are beneficial for the utility company at the level of intelligent lines, such as infrastructure and client management, fraud detection, network load balancing, blown fuse detection (due to impossibility of communicating with all the meters of a line), etc., can be launched.

The method object of the present invention is highly advantageous because detection is based on analyzing PLC communication signals, and it is therefore valid for detecting the location of meters that are remotely managed with standard PLC. The meters do no need any modification or any accessory element. The only infrastructure needed is located in the transformation center.

Many devices and systems identifying meters depending on a transformer are known, and in fact the applicant of this invention himself owns a patent with application number ES201100212, the object of which is also a system and method for detecting meters associated with a fuse of transformation centers, however, it involves the need to handle specific devices or add them to the meters, which is not required in the present invention, given that the existing arrangement itself is used without requiring user access. This same situation occurs in patent US4016429 which has the same purpose but similarly requires installing specific equipment in the meters of users, complicating the use of said devices, given that it does not use the same method as that which is the object of the present invention either. The same technological patent report which has been issued refers to other patent documents such as WO0076052, EP2330430, but as can be verified, none of said patent documents uses a method such as that which is the object of the present invention, and in terms of the devices of the system, basically the existing installations themselves have been used, in which inductive sensors are installed in a specific location and a whole new communication and control is carried out, giving rise to the present invention with the advantages and innovations for both the use and manufacture thereof and the results obtained with same, which are not in any way anticipated by any of the inventions that have been studied and to which reference has been made, after conducting the research, considering the present invention as novel and involving inventive step.

Document WO 2005059572 A1 discloses a power line communication system including a plurality of intelligent devices in communication with a power line and operable to monitor energy usage at a site and communicate usage data onto the power line, and a controller also in communication with the power line, wherein each intelligent device maintains a routing table identifying a first set of other intelligent devices downstream of it relative to the controller that it can communicate with directly and identifying a second set of other intelligent devices downstream of it relative to the controller that it can communicate with through one or more of the first set of other intelligent devices.

Document US 5995911 A describes a sensor apparatus for monitoring voltage and/or current in an electric circuit and a system for monitoring voltages and currents in a system wherein electricity is distributed in a plurality of circuits. A sensor apparatus is associated with each phase conductor in each of the circuits. The sensor apparatus senses the electricity in the phase conductor and provides a digital output that is representative of the sensed electricity in the phase conductor. The digital output preferably includes phasor data for the sensed phase conductor. The monitoring system includes a plurality of such sensor apparatuses. The plurality of sensor apparatuses are coupled to a digital data network that provides for the exchange of sensed data among nodes on the digital data network. On a node of the network, phasor data from some of the plurality of sensor apparatuses are summed or otherwise processed to obtain phasor data representative of a plurality of the circuits.

Document WO 2008125696 A2 discloses a load management controller for a household electrical installation comprising a pair of electricity supplies, a grid supply and a micro-generator supply, providing electricity to a plurality of sub-circuits. The household electrical installation has means to monitor the amount of electricity being supplied by the micro-generator supply and the amount of electricity being consumed in the household. The load management controller has means to access and use that information to control the supply of electricity to an energy storage sub-circuit to route surplus electricity supplied by the micro-generator to the energy storage sub-circuit. Furthermore, the load management controller can communicate with a remote electricity supplier to control the loads in the household to achieve better grid management and efficiency.

Document US 2005083206 A1 discloses an electrical monitoring device including an attachment arrangement adapted to attach the device, non-invasively, to an electrical supply line; a current sensor adapted to sense waveform characteristics relating to current flowing through the supply line; a voltage sensor adapted to sense voltage waveform characteristics of the supply line; and a processor programmed to calculate a power component using the current waveform characteristics and voltage waveform characteristics. The device also includes a wireless transmitter configured to transmit the power component to a monitoring location.

Description of the Invention

The present invention is based on the well-known fact that a transformation center is a node of the power distribution network, in which the medium voltage of the distribution network (10-30 KV) is converted into single-phase of 220 V low voltage AC or three-phase 400 V low voltage AC, for supplying power to client power supply points.

A variable number of low-voltage lines (hereinafter, lines) connecting the center with the power supply points (switchgears in buildings and homes) emerges from the transformation center. One and the same low-voltage line can supply power to a large number of clients and switchgears. Low-voltage power is distributed radially from the transformation center.

Detection of the meters of a line is a functionality carried out by this invention by means of using PLC technology. Detection of the meters is obtained by means of the method object of the present invention taking into account the injection of the PLC signal into the transformation centers.

The implementation necessary to achieve line detection is attained by extending the concept used until now in each low voltage board to each individual line. This is done non-intrusively using PLC inductive-receiving sensor elements which are capable of detecting the communication signal without disrupting same, installing a small active current sensor in the KHz range around the cable of the line (phase or neutral).

This is achieved using inductive receivers collecting the current induced in the cable by the PLC communication frames. It is only necessary to place the sensors in one of the phases of each line (always the same phase) or in the neutral of the lines.

These line sensor elements must store an internal table including the values of the received current, which is a parameter obtained from one of the variables of each maintenance frame, for each of the different service nodes (meters) it hears. Such frames are determined in the corresponding PLC standard, so the standard must be public and open (for example, PRIME)

Only the frames corresponding to specific messages (going upward from the meter to the concentrator) are computed to thereby count frames of the same type for all the sensors.

It is important to compute the level of received signal or level parameter (dBuV) and not the signal-to-noise ratio (SNR) or the error vector magnitude (EVM) in the computation, since the value of the Level parameter is always higher for a closer node in the network, according to Kirchhoff's nodal rule. The inductive sensor assures that the current (converted into voltage at the receiver inlet) is computed in each line.

The measurement concentrator is an element connected in the secondary side of the transformer of the transformation center. Said element is the base node of the PLC communication network and establishes communication with all the meters. Said concentrator will host an additional functionality for computing the line detection algorithm by means of PLC signal analysis.

The concentrator queries all the line sensors to know what is the current level they hear from each of the communications of the PLC meters. Upon obtaining said values, it stores an indexed table which allows applying Kirchhoff's nodal rule to the problem. As for a closed network, the sum of current in all the nodes is zero, this means that the current of the branch through which the PLC communication signal enters (the line in which it is arranged) will be higher in modulus compared with all the other lines.

In any node, the sum of the currents entering that node is equal to the sum of the currents exiting it. Equivalently, the sum of all the currents going through the node is equal to zero; this is Kirchhoff's nodal rule applied in the present invention and the formula of which is:

$$\sum_{k=1}^{n} I_k = I_1 + I_2 + I_3 \dots + I_n = 0$$

Once the data have been obtained, a statistical treatment of the received values is performed to eliminate possible spurious detections, and the line through which the meter communicates will be that showing, in the long term, a higher statistical current value, such that the meters and the line to which they belong are identified.

Brief Description of the Drawings

It is considered in a case such as the present in which the invention gives rise to a specific and concise method and system, that the best way to understand same is by means of the attached drawing in which the arrangement of all the elements forming it can be seen and in which:

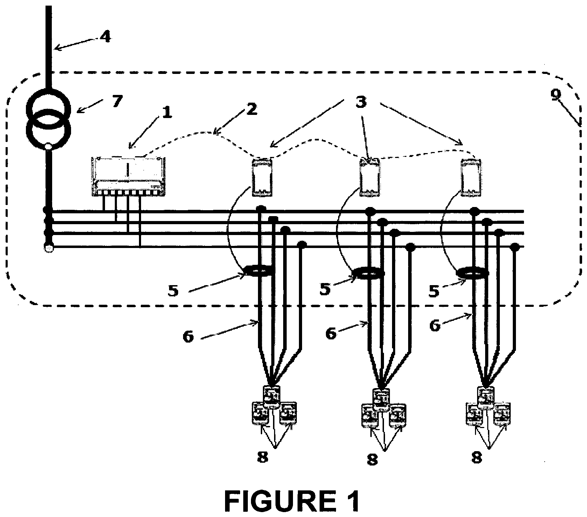

Figure 1 shows the depiction of the detection system that has been installed, said system being formed by a transformation center (9) having a medium-voltage input line (4) and a medium to low voltage transformer (7), and having at the output thereof a concentrator (1) managing all the communications, which concentrator is connected through the communication line (2) with each of the line receivers (3), which in turn receive the information collected by the inductive-receiving PLC sensors (5) located around the cable of the line (6) either in the phase cable or neutral cable, but all the inductive-receiving sensors (5) are located in the same cable of each line, all the lines (6) with all the phases and the neutral being depicted, each of them ending in the meters (8), which can be one or more in number, three meters being depicted in each line (6) by way of example.

Description of a Preferred Embodiment

The preferred embodiment of the system for detecting the meters of each low-voltage line of transformation centers, object of the present invention, is based on the fact that all transformation centers today are controlled using a PLC communication system, and in the present case, using more specifically the system known as PLC PRIME (hereinafter, PRIME), whereby meters communicate with the concentrator (1), and in terms of the system that is installed in a transformation center (9), said system must have the following components arranged in the following manner:

A PRIME concentrator (1) is connected through the communication lines (2) to PRIME receivers (3), which communicate with the PRIME inductive-receiving sensors (5) arranged around one of the three cables of the line (6) going to each of the PRIME meters (8) arranged in the entire network for each client.

This arrangement of elements uses the following method:

A) The inductors-receivers (5) collect the current induced in the cable by the PRIME communication frames, these inductors-receivers (5) store an internal table including the values of the received current, always being a parameter obtained from the PHY_DATA.level variable obtained from each ALIVE-type PRIME network maintenance communication frame, of each of the different PRIME meter service nodes (8) it hears. It is programmed so that only the frames corresponding to upward ALV_RSP messages from the meter (8) to the concentrator (1) are computed, or in any case always being a frame of the same type for all the sensors, always computing the Level parameter (dBuV). The inductive-receiving sensor (5) must be placed in each line (6) so as to assure computation of all the current (converted into input voltage).

B) The concentrator (1) queries all the inductive-receiving sensors (5) of the line (6) to know what is the current level they hear from each of the communications of the PRIME meters (8). Upon obtaining the values, it stores them in an indexed table allowing it to apply Kirchhoff's nodal rule, and by subsequently performing a statistical treatment of the received values, in the long term, it is deduced and established that the line (6) communicating with the meter (8) will be the one showing a higher statistical current value, the PRIME meter (8) depending on the line (6) thereby being identified, determining and identifying all the meters of each low-voltage line of transformation centers.

**Claims**

1. A system for detecting the meters of each low-voltage line of transformation centers, comprising the following components:

   - a transformation center (9) having low-voltage output lines (6), said low-voltage output lines (6) being in contact with final meters (8);
   - receivers (3) which communicate with the meters (8); and
   - a concentrator (1) included in said transformation center (9) and connected to a secondary side of a transformer (7), said concentrator (1) making contact and communicating with said receivers (3) through a communication line (2);

   wherein these components are in combination with one another and use a PLC communication protocol including frames corresponding to upward messages from the meter (8) to the concentrator (1), **characterized in that**:

- inductive-receiving sensors (5) are arranged around a same phase or neutral of each of the low-voltage output lines (6); and
the receivers (3) are in turn communicated with said inductive-receiving sensors (5) using said PLC communication protocol;

and **in that**:

A) the inductive-receiving sensors (5) collect the current induced in the cable of the low-voltage output lines (6) by said PLC communication frames and the inductive-receiving sensors (5) or the receivers (3) store an internal table including values of the induced current, said values being a parameter obtained from the PHY_DATA.level variable of each frame, the frames being a frame of the same type for all the sensors, the parameter being the Level parameter (dBuV); and
B) the concentrator (1) queries all the inductive-receiving sensors (5) of the low-voltage output lines (6) to know what is the current level they hear from each of the PLC communications of the meters (8), and upon having obtained the values the concentrator (1) stores the values in an indexed table, and by applying Kirchhoff's nodal rule and a statistical treatment of the received values deduces and establishes the one showing a higher statistical current value, the meter (8) depending on the line (6) thereby being identified, thus determining and identifying all the meters (8) of each low-voltage output line (6) of the transformation center (9).

**Patentansprüche**

1. System zur Erkennung der Zähler jeder Niederspannungsleitung von Transformationszentren, umfassend die folgenden Bestandteile:

- ein Transformationszentrum (9) aufweisend Niederspannungsausgabeleitungen (6), wobei die genannten Niederspannungsausgabeleitungen (6) in Kontakt mit Endzählern (8) sind;
- Empfänger (3), welche mit den genannten Zählern (8) kommunizieren; und
- einen Konzentrator (1), welcher in dem genannten Transformationszentrum (9) enthalten ist und an die Sekundärseite eines Transformators (7) angeschlossen ist, wobei der genannte Konzentrator (1) mit den genannten Empfängern (3) über eine Kommunikationsleitung (2) einen Kontakt herstellt und kommuniziert;

wobei diese Bestandteile in Kombination miteinander sind und ein PLC-Kommunikationsprotokoll verwenden, enthaltend Rahmen, welche Aufwärtsnachrichten vom Zähler (8) zum Konzentrator (1) entsprechen, **dadurch gekennzeichnet, dass**:

- Induktions-/Empfangssensoren (5) phasengleich oder im Nullpunkt jeder der Niederspannungsausgabeleitungen (6) angeordnet sind; und
die Empfänger (3) wiederum mit den genannten Induktions-/Empfangssensoren (5) unter Verwendung des genannten PLC-Kommunikationsprotokoll kommunizieren;

und dass:

A) die Induktions-/Empfangssensoren (5) den im Kabel der Niederspannungsausgabeleitungen (6) durch die PLC-Kommunikationsrahmen induzierten Strom abnehmen, und die Induktions-/Empfangssensoren (5) oder die Empfänger (3) eine interne, induzierten Strom enthaltende Tabelle speichern, wobei die genannten Werte ein aus der PHY_DATA.level-Variablen jedes Rahmens erhaltener Parameter sind, wobei die Rahmen ein Rahmen der gleichen Art für alle Sensoren sind, wobei der Parameter der Level-Parameter (dBuV) ist; und
B) der Konzentrator (1) alle Induktions-/Empfangssensoren (5) der Niederspannungsausgabeleitungen (6) abfragt, um den Strompegel zu erfahren, welchen sie aus jeder der PLC-Kommunikationen der Zähler (8) abhören, und nach Erhalten der Werte speichert der Konzentrator (1) die Werte in einer indexierten Tabelle, und durch Anwendung der Kirchhoffschen Knotenregel und einer statistischen Behandlung der empfangenen Werte denjenigen ableitet und feststellt, welcher den höchsten statistischen Stromwert zeigt, wobei der von der Leitung (6) abhängige Zähler (8) dadurch identifiziert wird, so dass alle Zähler (8) jeder Niederspannungsausgabeleitung (6) des Transformationszentrums (9) bestimmt und identifiziert werden.

**Revendications**

1. Un système pour détecter les compteurs de chaque ligne basse tension de centres de transformation comportant les éléments suivants:

- un centre de transformation (9) ayant des lignes de sortie basse tension (6), ces lignes de sortie basse tension (6) étant en contact avec les compteurs finaux (8);

- des récepteurs (3) qui communiquent avec les compteurs (8); et

- un concentrateur (1) compris dans ce centre de transformation (9) et connecté à un côté secondaire d'un transformateur (7), ce concentrateur (1) faisant contact et communiquant avec ces récepteurs (3) à travers une ligne de communication (2) ;

dans lequel ces éléments sont en combinaison entre eux et utilisent un protocole de communication PLC comprenant des trames correspondant à des messages ascendants du compteur (8) au concentrateur (1),

**caractérisé en ce que**:

- des capteurs inductifs-récepteurs (5) sont agencés autour d'une même phase ou neutre de chaque ligne de sortie de basse tension (6); et

les récepteurs (3) sont à leur tour communiqués avec ces capteurs inductifs-récepteurs (5) en utilisant le protocole de communication PLC; et **en ce que**

A) les capteurs inductifs-récepteurs (5) collectent le courant induit dans le câble des lignes de sortie basse tension (6) par ces trames de communication PLC et les capteurs inductifs-récepteurs (5) ou bien les récepteurs (3) stockent un tableau interne comprenant des valeurs du courant induit, ces valeurs étant un paramètre obtenu de la variable de niveau PHY-DATA de chaque trame, les trames étant une trame du même type pour tous les capteurs, le paramètre étant le paramètre Niveau (dBuV); et

B) le concentrateur (1) interroge tous les capteurs inductifs-récepteurs (5) des lignes de sortie basse tension (6) pour savoir quel est le niveau de courant qu'ils entendent de chacune des communications PLC des compteurs (8), et après avoir obtenu les valeurs le concentrateur (1) stocke les valeurs dans une table indexée et en appliquant la loi des noeuds de Kirchoff et un traitement statistique des valeurs reçues déduit et établit celle montrant une valeur de courant statistique plus élevée, le compteur (8) dépendant sur le ligne (6) étant ainsi identifié, en déterminant et en identifiant donc tous les compteurs (8) de chaque ligne de sortie basse tension (6) du centre de transformation (9).

**FIGURE 1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- ES 201100212
- US 4016429 A
- WO 0076052 A
- EP 2330430 A
- WO 2005059572 A1
- US 5995911 A
- WO 2008125696 A2
- US 2005083206 A1